# FASCICULE DE BREVET EUROPEEN

(11) **EP 2 138 453 B1**
(45) Date de publication et mention de la délivrance du brevet: **21.11.2012**
(21) Numéro de dépôt: 09290473.9
(22) Date de dépôt: 22.06.2009
(51) Int. Cl.: B81C 1/00

(54) **Procédé de fabrication d'une structure électromécanique comportant au moins un pilier de renfort mécanique**
Verfahren zur Herstellung einer elektromechanischen Struktur, die mindestens eine Stütze zur mechanischen Verstärkung umfasst
Method for manufacturing an electromechanical structure comprising at least one mechanical reinforcement post

(30) Priorité: 23.06.2008 FR 0803495
(43) Date de publication de la demande: 30.12.2009
(73) Titulaire: Commissariat à l'Énergie Atomique et aux Énergies Alternatives, 75015 Paris (FR)
(72) Inventeur: Larrey, Vincent, 38140 La Murette (FR); Perruchot, François, 38000 Grenoble (FR); Diem, Bernard, 38130 Echirolles (FR); Clavelier, Laurent, 38000 Grenoble (FR); Robert, Philippe, 38000 Grenoble (FR)
(74) Mandataire: Rataboul, Xavier

(56) Documents cités:
- US-A- 5 987 989
- US-A1- 2004 099 928
- US-A1- 2004 256 689
- SEOK ET AL: "A high performance mixed micromachined differential resonant accelerometer" PROCEEDINGS OF IEEE SENSORS 2002. ORLANDO, FL, JUNE 12 - 14, 2002, vol. 2, 12 juin 2002 (2002-06-12), pages 1058-1063, XP010605258 ISBN: 978-0-7803-7454-6

## Description

La présente invention a pour objet un procédé de fabrication d'une structure électromécanique présentant un substrat de type couche monocristalline (notamment silicium, germanium, perovskite, quartz) sur une couche sacrificielle notamment pour un microsystème ou système microélectromécanique ("MEMS") ou nanomécanique (NEMS), ledit substrat présentant au moins une région de renfort mécanique (ou "pilier").

Les technologies dites de surface (par opposition aux technologies de volume) permettent de réduire la taille des structures électromécaniques (MEMS / NEMS) réalisées sur silicium. Ces technologies reposent sur l'utilisation d'un empilement d'au moins trois couches : une couche mécanique (typiquement de 0,1 à 100 µm), une couche sacrificielle (typiquement de 0,1 à quelques µm) et un support (typiquement de 10 à 1000 µm), la gravure chimique sélective de la couche sacrificielle permettant de réaliser dans la couche mécanique des structures fonctionnelles localement indépendantes du support.

Les zones non gravées de la couche sacrificielle permettent de réaliser des zones dites d'ancrage ou de renfort mécanique (ou « piliers ») par lesquelles la structure mécanique est reliée au support.

Dans des procédés connus permettant d'intégrer de tels piliers, par exemple celui décrit dans la Demande WO 2006/035031, l'assemblage par adhésion moléculaire d'un substrat en silicium est effectué par dessus la couche d'oxyde qui a fonction de couche sacrificielle lors de la fabrication finale de la structure du MEMS. Lors de cette fabrication finale, des tranchées sont ménagées à travers le substrat de silicium rapporté par adhésion moléculaire et la couche sacrificielle est enlevée. Les piliers servent de support au microsystème. Au cours de cette opération, la zone d'interface entre le substrat rapporté et le reste de la structure est soumis à l'attaque chimique (en général par de l'acide HF), ce qui conduit à des géométries mal contrôlées si l'interface n'est pas parfaite car la vitesse de gravure est variable, et il existe un risque révélation de l'interface de collage. Après enlèvement de la couche sacrificielle, et libération de la structure MEMS, l'intégrité mécanique n'est pas optimale.

D'autres procédés connus qui reflètent cet inconvénient sont décrits notamment dans le Brevet US 6,916,728 (figures 9 et 10 ; colonne 6, lignes 20 à 47) et US 6,952,041 (figures 4a à 4f ; colonne 8, ligne 28 à colonne 9, ligne 49).

L'article de T. YAMAMOTO et Collaborateurs "Capacitive Accelerometer with High Aspect Ratio Single crystalline Silicon Microstructure Using the SOI Structure with Polysilicon-Based Interconnect technique" paru dans MEMS 2000, the thirteenth annual international conference, 23-27 janvier 2000, Miyazaki, Japan p. 514-519 ne présente pas cet inconvénient. Toutefois, les piliers sont réalisés en poly Si épais et leur dimension latérale est limitée par la technologie. Les piliers sont réalisés dans la couche sacrificielle par remplissage à partir d'un dépôt de Si poly. Le remplissage se fait par les flancs de la cavité donc l'épaisseur de remplissage est supérieure à la moitié de la largeur des piliers. Pour ne pas avoir à déposer des couches de Si poly trop épaisses (maximum typiquement de 3 µm), la dimension latérale du pilier est limitée typiquement à 5 µm.

L'article de S. Seok et al. "A high performance mixed micromachined differential resonant accelerometer", paru dans Proceedings of IEEE Sensors 2002, Orlando, FL, vol. 2, 12 juin 2002, pages 1058-1063, décrit un procédé de manufacture similaire. Les piliers sont également réalisées en polysilicium épais. Selon ce document, les piliers comportent en outre une couche de polysilicium dopé qui sert de niveau d'interconnexion ainsi qu'une couche de passivation de nitrure de silicium.

Si le remplissage s'effectue par le fond de la cavité, l'épaisseur à déposer est alors de l'ordre de 3 à 5 fois l'épaisseur de la couche sacrificielle pour pouvoir planariser la couche.

L'article de G. J. O'BRIEN et D.J. MONK intitulé "MEMS process flow insensitive to timed etch induced anchor perimeter variation on SOI and bulk silicon wafer substrates" paru dans IEEE 2000, p. 481-484 et le Brevet US 6 913 941 notamment en ses figures 27 et 28 montrent des piliers qui traversent à la fois la couche sacrificielle et la couche mécanique. Dans ce cas également, le remplissage des cavités se fait par les flancs ce qui limite la dimension latérale du pilier. Le remplissage de Si poly peut être précédé par le dépôt d'une couche fine de nitrure pour isoler l'extérieur du pilier.

Les procédés connus sont donc limités à des piliers dont la largeur est limitée par l'épaisseur de la couche de Si poly utilisée pour les remplir. Pour des raisons technologiques et de coûts, les épaisseurs utilisées sont typiquement de l'ordre de quelques µm, ce qui limite les dimensions latérales des piliers à quelques µm.

Il existe une autre raison pour laquelle les procédés connus limitent la dimension latérale des piliers qui sont remplis à l'aide de Si poly lorsque le procédé contient le collage d'un second substrat de silicium (article précité de T. YAMAMOTO).

Pour faciliter le collage d'un premier substrat silicium contenant une couche épaisse (typiquement de quelques µm) d'un matériau différent du silicium (stress ou coefficient de dilation différent) sur un second substrat de silicium, un procédé connu consiste à réaliser une seconde couche du second matériau sur l'autre face du premier substrat de même épaisseur que la première couche pour compenser les déformations induites par les différences entre le matériau et le silicium et faciliter la mise en contact des deux substrats lors du collage. Dans un procédé tel que décrit par YAMAMOTO, le premier substrat contient comme couche épaisse au moins la couche sacrificielle en Si02. Dans les procédés connus de réalisation de piliers dans la couche sacrificielle, le matériau utilisé pour le remplissage est du Si poly épais. L'état de contrainte du Si polycristallin (au moment du dépôt ou lors du chauffage) étant différent de celui du SiO2, limiter les dimensions latérales des piliers permet de limiter l'inhomogénéité de la couche sacrificielle.

La présente invention propose un procédé de fabrication qui permette de fabriquer des piliers de renfort mécanique de manière versatile, c'est-à-dire sans limitation sur la largeur, cette largeur étant fonction de l'application recherchée, et qui puissent être à volonté isolants ou conducteurs, notamment pour permettre une prise de contact, tout en évitant l'inconvénient d'un risque de révélation de l'interface de collage d'un substrat sur la couche sacrificielle. Une variante du procédé permet de limiter la topologie provenant de la fabrication des piliers.

L'invention concerne ainsi un procédé de fabrication d'une structure électromécanique, le procédé mettant en oeuvre un premier substrat comportant au moins une couche en matériau monocristallin recouverte d'une couche sacrificielle présentant une surface libre, la structure présentant au moins un pilier de renfort mécanique logé dans ladite couche sacrificielle, caractérisé en ce qu'il comporte:
a) la réalisation, par gravure de la couche sacrificielle, au moins sur toute son épaisseur, d'au moins une région de puits définissant au moins un dit pilier mécanique;
b) le dépôt d'une première et d'une deuxième couches de fonctionnalisation respectivement en un premier et en un second matériaux de fonctionnalisation, par rapport auxquels la couche sacrificielle est apte à être gravée sélectivement, l'un des matériaux de fonctionnalisation étant conducteur et l'autre isolant, la première couche de fonctionnalisation remplissant au moins partiellement au moins une région de puits et recouvrant la surface libre de la couche sacrificielle au moins autour de la ou des régions de puits;
b') le dépôt d'une couche de remplissage isolante en un matériau de remplissage différent du premier et du deuxième matériaux de fonctionnalisation pour terminer le remplissage de la ou des régions de puits, ladite couche de remplissage recouvrant au moins partiellement la première et/ou la deuxième couches de fonctionnalisation autour de la ou des régions de puits et une planarisation de la couche de remplissage, le ou les piliers étant formés par la superposition d'au moins du premier ou du deuxième matériaux de fonctionnalisation et du matériau de remplissage dans la ou les régions de puits;
c) l'assemblage du premier substrat avec un deuxième substrat, puis la réalisation d'une ou plusieurs ouvertures à travers ladite couche en matériau monocristallin et la libération de la structure électromécanique par enlèvement au moins partiellement de la couche sacrificielle, une couche d'adhésion étant ainsi formée par la couche de remplissage planarisée réalisée sur le premier substrat avant collage.

On remarquera que lorsque les piliers ne traversent que la couche sacrificielle, le remplissage par le deuxième matériau ne concerne qu'une épaisseur sensiblement égale à celle de la couche sacrificielle, et dès lors, il n'y a pas de limitation à la réalisation de piliers de grande largeur (par exemple quelques dizaines de µm et plus précisément 50 µm par exemple).

Le matériau monocristallin peut être choisi notamment parmi le Si, le Ge, le quartz ou bien encore un perovskite.

Le substrat peut être un substrat épais de Si ou bien un substrat, notamment de type SOI ou encore un substrat avec couche d'arrêt (SiGe, Si poreux). La gravure de la couche sacrificielle pour former au moins un puits peut être réalisée à travers au moins une ouverture d'un masque déposé sur la couche sacrificielle.

La planarisation de la deuxième couche peut être poursuivie jusqu'à atteindre la première couche de fonctionnalisation, notamment pour que la deuxième couche ne subsiste que dans les régions de puits.

Le procédé comporte:
c) un assemblage avec un deuxième substrat notamment en silicium, à l'opposé du premier substrat. Ce deuxième substrat est avantageusement de même nature que la couche monocristalline du premier substrat.

Le deuxième substrat présente avantageusement une surface d'assemblage recouverte d'une couche d'adhésion, par exemple d'oxyde de Si.

Avant l'étape c, le procédé peut mettre en oeuvre un dépôt d'une couche d'adhésion sur le premier et/ou le deuxième substrat et formant interface entre ces deux substrats. Une couche d'adhésion dans le deuxième matériau peut être réalisée sur le premier substrat avant collage.

Le premier matériau peut être par exemple du nitrure de silicium ou du Si polycristallin. Le deuxième matériau peut être de l'oxyde de silicium, ou du Si polycristallin dopé ou non, un métal ou un polymère.

Le procédé ensuite présente une étape d de gravure de la couche sacrificielle à travers au moins une ouverture traversante du premier substrat pour libérer la structure électromécanique. Le premier substrat est avantageusement aminci avant la réalisation de l'étape d par une ou plusieurs techniques d'amincissement (planarisation mécano-chimique dite procédé CMP, rectification, gravure sèche, gravure humide...).

Avant ou après l'étape b' de dépôt d'une couche de remplissage et de planarisation de la couche de remplissage, le procédé peut comporter une étape b" de réalisation au moins dans la première couche de fonctionnalisation lorsque celle-ci est de nature isolante et éventuellement dans la couche de remplissage, d'au moins un puits s'étendant au moins jusqu'à la couche sacrificielle ainsi que de dépôt d'un matériau conducteur au moins dans le ou lesdits puits pour former au moins une électrode.

Il peut être avantageux de déposer entre les étapes b' et b" une couche additionnelle du premier matériau de manière à épaissir la première couche isolante, notamment lorsque la planarisation de la deuxième couche a été poursuivie jusqu'à atteindre la première couche.

Il peut être prévu après b" le dépôt d'une couche comportant au moins une région conductrice, par exemple une région plane formant un plan de masse.

Pour réaliser les piliers conducteurs permettant des prises de contact, notamment une interconnexion, la première couche peut être en matériau conducteur, notamment en Si polycristallin dopé, en un métal ou en un alliage métal/semi-conducteur.

Le procédé comporte la première couche de fonctionnalisation ainsi qu'une deuxième couche de fonctionnalisation, l'une des couches de fonctionnalisation étant conductrice et l'autre isolante, il comporte entre b et b' une étape b₀ de dépôt de la deuxième couche de fonctionnalisation, celle des couches de fonctionnalisation qui est conductrice formant un premier niveau d'interconnexion.

La deuxième couche de fonctionnalisation peut être en un troisième matériau choisi parmi le nitrure de silicium, le Si polycristalin dopé ou isolant, ou bien un métal

Le procédé peut être caractérisé en ce que la première couche de fonctionnalisation ne couvre qu'une partie des régions de puits, l'autre partie des régions de puits étant couverts par la seconde couche de fonctionnalisation, permettant la formation à la fois de piliers conducteurs et de piliers isolants.

La couche sacrificielle peut être couverte par la réunion des première et deuxième couches de fonctionnalisation.

Alternativement, la deuxième couche de fonctionnalisation peut couvrir l'ensemble de la surface de la couche sacrificielle et de la première couche de fonctionnalisation.

Le deuxième matériau de remplissage peut être le même que celui qui constitue la couche sacrificielle.

Selon une variante où la première couche de fonctionnalisation est isolante et donc la deuxième couche de fonctionnalisation est conductrice, le procédé peut comporter après l'étape b₀ une étape b'₁ de dépôt d'une couche isolante formant une troisième couche de fonctionnalisation.

La planarisation de la couche de remplissage peut être alors poursuivie jusqu'à atteindre la troisième couche de fonctionnalisation.

Le procédé peut être caractérisé en ce qu'il comporte après b'₁, une étape b'₂) de réalisation d'au moins un via dans ladite troisième couche de fonctionnalisation et d'un dépôt conducteur au moins dans ce via, ce dépôt formant un contact sur la deuxième couche de fonctionnalisation conductrice de façon à former un deuxième niveau d'interconnexion.

Le procédé peut être caractérisé en ce qu'il comporte des dépôts successifs de couches de fonctionnalisation additionnelles alternativement en matériau conducteur et en matériau isolant et la réalisation de via de façon à former des niveaux d'interconnexion supplémentaires à partir des couches conductrices.

Le dernier desdits niveaux d'interconnexion peut couvrir l'ensemble de la surface pour former un plan de masse.

Alternativement, le dernier niveau d'interconnexion est plan et comporte des plages d'interconnexion pour permettre lors de l'assemblage avec le deuxième substrat de connecter des éléments du deuxième substrat à la structure électromécanique.

L'invention concerne également une structure électromécanique selon la revendication 21.

L'invention sera mieux comprise à la lecture de la description ci-après en liaison avec les dessins dans lesquels :
- les figures 1a à 1f illustrent un procédé qui permet de manière préférée de réaliser des renforts ou piliers bi-matière, la figure 1d' étant une variante avantageuse de ce procédé,
- les figures 2a à 2d illustrent une variante du procédé selon l'invention dans laquelle il existe des piliers dits conducteurs ou isolants, et les figures 2c1, 2c2 et 2d' en illustrent un mode de réalisation ayant un deuxième niveau d'interconnexion,
- les figures 3a à 3d illustrent une variante du procédé selon l'invention permettant la réalisation de niveaux d'interconnexion en technologie planaire, dont les figures 3c1 à 3c8 sont une implémentation avec plusieurs niveaux d'interconnexion.
- la figure 4 représente à titre d'exemple un capteur de pression réalisé avec le procédé des figures 1a à 1f.

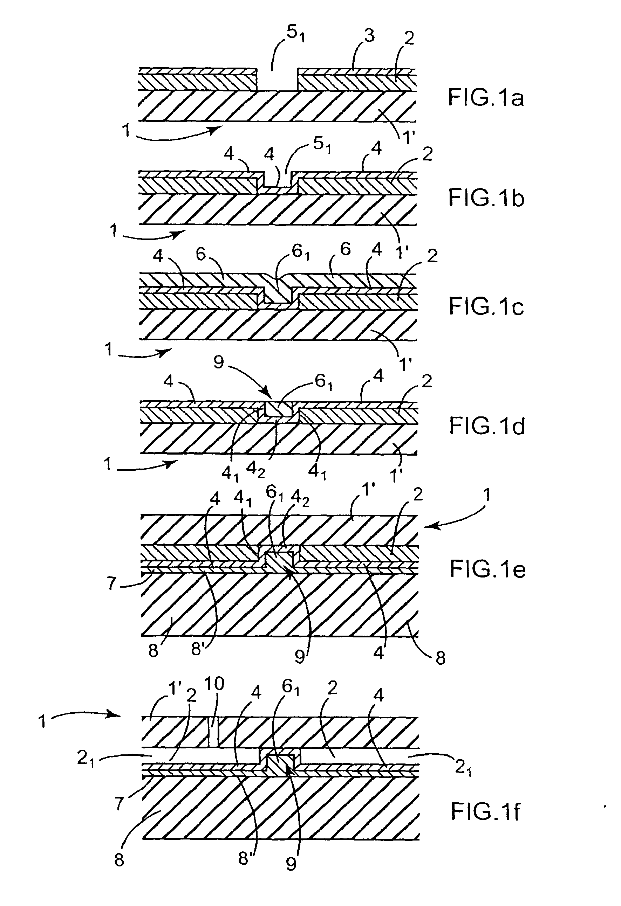

Les figures 1a à 1f illustrent un exemple, qui permet la réalisation de piliers isolants à partir de tranchées de grande largeur (par exemple quelques dizaines de µm et plus précisément 50 µm par exemple. Le procédé part d'un substrat 1 présentant au moins une couche monocristalline 1' (par exemple de Si monocristallin) revêtue d'une couche sacrificielle 2 (par exemple Si02). La couche 1' peut représenter la totalité du substrat (substrat Si épais) ou une partie seulement (par exemple la couche supérieure d'un substrat SOI ou autre type de substrat présentant une couche d'arrêt de gravure) De préférence, le substrat de départ est un substrat silicium comportant une couche d'arrêt en SiGe monocristallin (non représenté sur la figure) et une couche 1' en silicium monocristallin. La couche 2 peut être un oxyde déposé en phase vapeur à basse pression (LPCVD) ou avec l'aide d'un plasma (PECVD), ou encore réalisée par oxydation thermique de la couche 1'. Son épaisseur peut être comprise entre 200 nm et 5 µm (typiquement 2 à 3 µm).

Une couche 3 de résine photosensible est exposée pour permettre de réaliser une ou plusieurs zones telles que 5₁ dans la couche 2 (figure 1a), ces zones servant de réserve pour la réalisation de la ou des régions de renfort. Les régions de renforts peuvent être des zones ouvertes, ou bien des zones fermées par exemple annulaires ou polygonales comme dans le cas d'un capteur de pression.

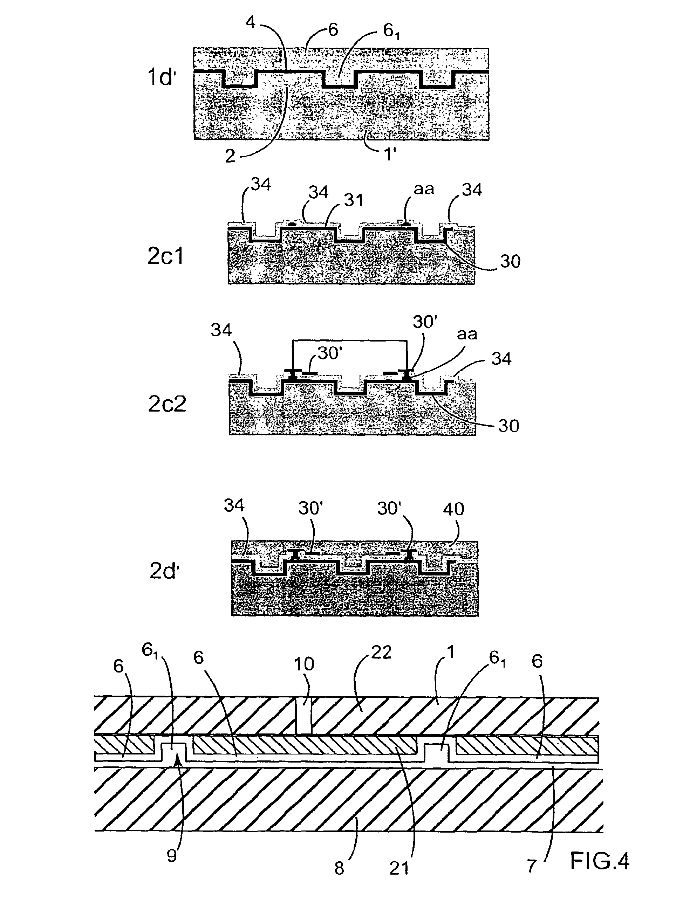

Après enlèvement de la résine 3, une couche de fonctionnalisation 4 par exemple en nitrure de silicium d'épaisseur comprise par exemple entre 10 nm et 500 nm est déposée sur la couche 2, en 4₁ sur les parois latérales de la ou des zones 5₁ et 4₂ sur la face mise à nu du substrat 1 (figure 1 b) (Rem :-> 41 et 42 ne sont pas représentés sur la figure). Le dépôt du nitrure peut être effectué par dépôt en phase vapeur notamment basse pression ("LPCVD") ou bien avec un plasma ("PECVD") ou à couche atomique ALCVD (Atomic Layer CVD). Cette couche 4 peut être également en polysilicium (dopé ou non) ou en métal ou en alliage métal/semiconducteur. Elle doit présenter une sélectivité de gravure par rapport à la couche sacrificielle. Cette couche ne couvre pas nécessairement toute la surface de la couche sacrificielle (elle peut-être gravé localement). Elle permet de réaliser des piliers isolants ou conducteurs suivant la nature du matériau de la couche de fonctionnalisation 4, servant d'arrêt de gravure pour la couche sacrificielle et de contact électrique vers la couche mécanique 1' lorsque les piliers sont conducteurs ;

Alternativement, il peut être prévu un ancrage de la région 42 de la couche 4 dans la couche 1' en utilisant la technique décrite dans la Demande de Brevet français FR 2 859 201. Il s'agit de poursuivre la gravure de la zone 51 dans le Si pour assurer ensuite un ancrage du pilier sur une faible profondeur (par exemple 100 à 500 nm) par la région 42, sans toutefois que le pilier ne traverse ladite couche 1'. Les zones gravées de la couche sacrificielle permettent de réaliser dans la couche mécanique des structures fonctionnelles localement indépendantes du support.

Les zones non gravées de la couche sacrificielle permettent de réaliser des zones dites d'ancrage ou de renfort mécanique (ou « piliers »). La couche 4 est appelée couche de fonctionnalisation car elle permet d'ajouter des fonctions à la couche sacrificielle : des piliers réalisés avec des arrêts de gravure, des électrodes sous la couche sacrificielle, des connexions électriques entre la couche mécanique et ces électrodes ou entre des parties de la couche mécanique non reliées.

Une autre couche isolante ou non isolante 6 dite couche de remplissage en un matériau différent de celui de la couche 4, par exemple en SiO2 est ensuite réalisée (par LPCVD ou PECVD par exemple) de manière à remplir la ou les zones 51 et à recouvrir tout ou partie de la couche 4 recouvrant la couche 2 (figure 1c). En particulier, il est possible après un recouvrement total représenté à la figure 1c de graver localement la couche 6 de manière à n'en laisser subsister qu'une partie 6' qui entoure la ou les régions 51 (figure 1c1 (Rem->pas de figure 1c1)) (voir Schiltz and Pons ["Two-Layer Planarization Process", J. Electrochem. Soc. 133:178-181 (1986)]). Si la couche de remplissage est dans le même matériau que la couche sacrificielle comme dans l'exemple donné, la couche 2 doit recouvrir la totalité de la surface.

Ensuite, à partir de la configuration de la figure 1c ou de la figure 1 c1, on réalise une planarisation de la couche 6 ou 6' de remplissage pour terminer la ou les zones de renfort mécanique ou piliers 9 constitués par les régions 4₁, 4₂, 6₁ (figures 1d et 1d'). Le procédé utilisé à cet effet est par exemple une planarisation mécano-chimique CMP. Cette planarisation peut être conduite de manière à n'enlever qu'une partie de l'épaisseur de la couche 6 (figure 1d') ou bien comme représenté à la figure 1d être poursuivie pour s'interrompre sur la couche 4 de nitrure de silicium en laissant subsister une face sensiblement plane au niveau du pilier (4₁, 4₂, 6₁). On dépose ensuite une mince couche d'adhésion 7, par exemple d'oxyde (suivie accessoirement d'une CMP) qui permet ensuite un report par collage moléculaire d'un substrat 8 en Si monocristallin (collage moléculaire Si - SiO₂), éventuellement oxydé à sa surface en contact avec la couche 7 (collage moléculaire SiO₂ - SiO₂) (figure 1 e). Ce dépôt est optionnel dans le cas de d'un enlèvement seulement d'une partie de l'épaisseur de la couche 6 (figure 1d'). Il peut également ne pas être réalisé dans le cas de la figure 1d mais cela entraîne le collage sur une interface hétérogène qui, à conditions égales, donne des énergies de collage plus faibles.

Une raison importante du choix du SiO2 pour le remplissage est sa capacité à être déposé en couche épaisse avec peu de contrainte mécanique par rapport à d'autres matériaux tels que nitrure de silicium ou polysilicium ainsi que son aptitude à la planarisation par CMP bien maîtrisée. De plus, dans le cas où la couche sacrificielle est également en SiO2, cela permet de limiter l'inhomogénéité de la couche sacrificielle après fonctionnalisation ; elle est très majoritairement composée d'un seul matériau. La couche de remplissage est donc réalisée de manière préférentielle dans le même matériau que la couche sacrificielle.

Pour obtenir un substrat 1 de silicium d'épaisseur adaptée à la réalisation d'un système MEMS (par exemple 5 à 50 µm d'épaisseur), on part en général d'un substrat de départ plus épais que la seule couche 1' et ce substrat est ensuite aminci à l'épaisseur désirée après collage moléculaire du substrat 8. Cet amincissement peut être réalisé par une rectification suivie d'une CMP.

Dans le cas où la couche 1' est en silicium monocristallin réalisé sur une couche d'arrêt en SiGe, la partie silicium du substrat de départ est rectifiée jusqu'à une épaisseur d'environ 10 µm. L'épaisseur est déterminée par la précision disponible pour cette étape de rectification et aussi de manière que la couche 1' ne comporte pas de zones écrouies, zones créées lors de l'étape de rectification. C'est donc une fonction en particulier de la vitesse de rectification souhaitée.

L'épaisseur de Si restante du substrat de départ est ensuite enlevée par gravure chimique, avec arrêt sur la couche d'arrêt en SiGe. Il existe différentes méthodes connues pour la gravure de Si avec arrêt sur SiGe. On citera les méthodes de gravure humides (sauces de type TMAH ou KOH, cf rapport biblio sur les gravures sélectives) ou en gravure sèche (Japanese Journal of Applied Physics , Vol. 43, No. 6B, 2004, pp. 3964-3966 , 2004 The Japan Society of Applied Physics). La couche d'arrêt est ensuite enlevée par gravure chimique avec arrêt sur le Si de la couche 1.

Il existe différents procédés connus de gravure du SiGe avec arrêt sur Si. On citera des procédés de gravure HCI en température (Selective chemical vapour etching of Si1-xGex versus Si with gaseous HCI by Y Bogumilowicz, J M Hartmann, J M Fabri and T Billon in Semicond. Sci. Technol. 21 No 12 (December 2006) 1668-1674), des procédés de gravure chimique à base de sauces de type HNA et des procédés de gravure sèche (Japanese Journal of Applied Physics, Vol. 43, No. 6B, 2004, pp. 3964-3966, 2004 The Japan Society of Applied Physics). Cette utilisation d'un substrat de départ composé d'une couche de SiGe sur silicium épais permet de mieux contrôler l'épaisseur finale de la couche 1.

Le dépôt de la couche 7 est optionnel, le report du substrat 8 pouvant être effectué par la technique décrite dans la Demande de Brevet WO 2006/035031. Cette technique permet d'assurer un collage moléculaire entre le substrat 8 et la surface comportant deux matériaux différents, notamment le nitrure de Si et le SiO₂.

Le procédé se poursuit (figure 1e) en position retournée qui est celle de procédés de l'art antérieur exposés dans la partie introductive de la description.

Ensuite, le procédé selon l'invention comprend une étape de libération de la structure électromécanique par enlèvement, au moins partiellement, de la couche sacrificielle 2. La suppression de la couche sacrificielle peut être faite par des ouvertures traversantes 10, mais également par tout autre moyen.

On effectue une gravure de la couche 1' en Si, pour réaliser une ou plusieurs ouvertures 10 (figure 1f). Ces ouvertures 10 qui peuvent également servir à définir la structure du système MEMS dans la couche 1' sont utilisées pour enlever la couche sacrificielle 2 en formant une ou plusieurs cavités 21 à l'aide d'acide fluorhydrique HF en phase liquide ou vapeur dans le cas d'une couche de SiO₂ de sorte que la structure active de la figure 1 est maintenue par le ou les piliers (4₁, 4₂, 6₁). Les matériaux du pilier ont été choisis de manière à être sélectifs vis-à-vis de la solution de gravure de la couche sacrificielle. On réalise ainsi la structure mécanique dans la couche 1'qui peut être appelée couche mécanique.

On voit que la zone d'interface 8' entre le substrat 8 rapporté par adhésion moléculaire et la couche 7 est à l'écart de toute attaque chimique lors de la réalisation de la ou des ouvertures 10 et de la libération de la structure MEMS par enlèvement à l'acide HF de la couche sacrificielle 2.

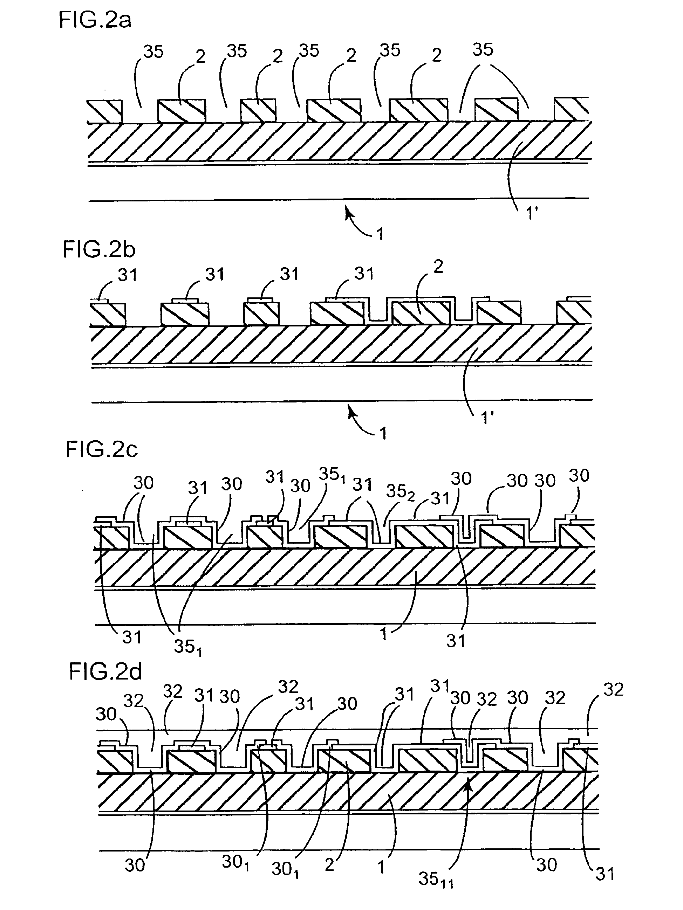

Les figures 2a à 2e illustrentun exemple préféré du procédé selon l'invention dans lequel les piliers incluent une couche conductrice, ici en Si polycristallin, qui permet de réaliser des prises de contact, voire des niveaux d'interconnexions multiples et combinant des piliers conducteurs et des piliers isolants.

La figure 2a montre, comme à la figure 1a, la réalisation de puits 35 dans la couche sacrificielle 2 qui est par exemple en SiO₂, sur un substrat 1 comportant notamment une couche 1' par exemple en Si monocristallin.

La figure 2b montre le dépôt localisé (dépôt sur toute la surface puis gravure localisée) d'une première couche de fonctionnalisation 31, isolante, en nitrure de Si, en particulier sur les zones de puits où des piliers isolant seront réalisés. Cette couche de nitrure permet de réaliser des piliers isolants et d'isoler chimiquement la couche en Si polycristallin (voir description ci-après) de la couche mécanique 1 et la couche sacrificielle 2 de la couche de remplissage lorsque celle-ci est dans le même matériau que la couche sacrificielle.

La figure 2c montre le dépôt localisé (notamment par dépôt sur toute la surface puis gravure localisée) d'une deuxième couche de fonctionnalisation 30, conductrice, par exemple en Si polycristallin dopé dans les régions de puits 35₁ où il est souhaité de réaliser des piliers ayant également une fonction conductrice notamment pour réaliser des prises de contact sur la couche 1 (couche mécanique). En dehors des régions de puits, cette couche peut également servir à réaliser un premier niveau d'interconnexions ou des électrodes. Les autres puits 35₂ peuvent être dépourvus de dépôt de Si polycristallin pour limiter les couplages capacitifs au niveau des piliers isolants. Ce n'est pas le cas si pour des raisons de topologie, une connexion électrique doit être passée de part et d'autre d'un pilier isolant comme illustré dans les puits 35₁. On notera que la couche de fonctionnalisation isolante 31 peut être déposée après la couche de fonctionnalisation conductrice 30. Mais si les matériaux des couches 1 et 30 ne peuvent pas être gravés sélectivement, la gravure de la couche de fonctionnalisation dans les puits doit dans ce cas se faire en deux temps : la gravure de la couche de fonctionnalisation dans les puits 35₁, puis après la réalisation de la couche 30, la gravure de la couche de fonctionnalisation dans les puits 35₂.

La figure 2d montre le dépôt d'une couche 32 de remplissage, par exemple en SiO₂, pour remplir les puits 35. Ce dépôt est ensuite planarisé en utilisant une technique d'amincissement, par exemple selon le procédé CMP.

Les piliers comportent ainsi soit une couche conductrice externe 31 en Si polycristallin, soit une couche isolante 30 et une couche 32, par exemple en SiO₂, qui en constitue le coeur. Ils sont donc bi ou tri-matière selon les cas.

Les figures 2c1, 2c2 et 2d' illustrent un mode de réalisation incluant un deuxième niveau de couche d'interconnexion, ici en Si polycristallin.

Ce second niveau de couche d'interconnexion permet de réaliser des pistes connectant électriquement deux zones conductrices en Si polycristallin 30 (piliers conducteurs ou électrodes) non connectées par le premier niveau pour des raisons de topologie.

La figure 2c1 montre le dépôt d'une couche isolante 34 (nitrure ou oxyde) servant à isoler les couches d'interconnexion. Cette couche est localement gravée avec arrêt sur la couche 30 ce qui permet de ménager des accès électriques (aa) sur les zones 30 à connecter.

La figure 2c2 montre la réalisation d'une seconde couche conductrice localisée qui permet de relier les accès électriques (aa) suivant le schéma d'interconnexion réalisé. Des vias sont ainsi réalisés entre les premier et deuxième niveaux d'interconnexion.

Ces opérations (dépôt de la couche isolante avec ouverture, dépôt localisée de Si polycristallin) peuvent être répétées pour réaliser des niveaux multiples d'interconnexion à partir de couches additionnelles de fonctionnalisation conductrices et isolantes.

En particulier, il peut être réalisé comme dernière couche une couche couvrant la totalité du composant, connecté éventuellement à une ou plusieurs pistes des couches inférieures servant de plan de masse au système MEMS.

Ce plan de masse peut suivant les cas également être réalisé sur le même niveau que les dernières pistes et n'être alors que partiel.

Finalement la figure 2d' montre le dépôt d'une couche 40 de remplissage et de collage par exemple en oxyde de silicium, sur la structure obtenue selon la figure 2c2.

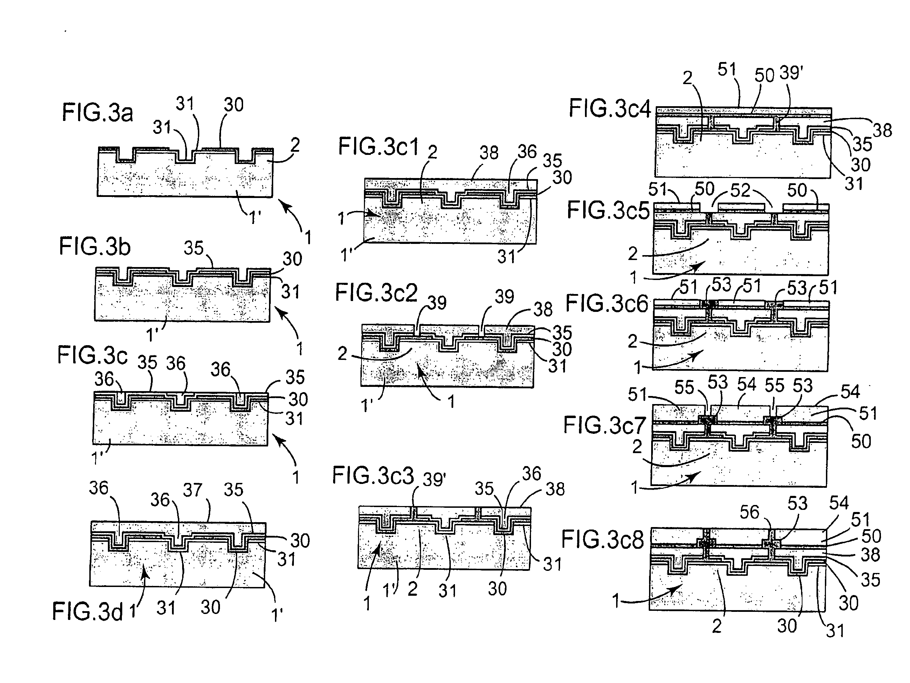

Les figures 3a à 3d montrent une autre variante du procédé de réalisation permettant de limiter la topologie due aux différentes couches déposées : chaque réalisation de dépôt localisé augmente la topologie de l'empilement final initialement crée par la réalisation des zones telles que 5₁ dans la couche sacrificielle.

La figure 3a montre le substrat après le dépôt successif des couches de nitrure 31 et de Si polycristallin 30 avec un procédé tel que celui décrit en relation avec les figures 2a à 2c. Pour obtenir une surface de référence plane, la couche de SiN 31 est réalisée sur l'ensemble du substrat hormis les zones de piliers en Si polycristallin (couche 30). De la même manière, la couche de Si polycristallin est réalisée sur l'ensemble de la surface de la couche 2 en n'enlevant que les zones permettant d'isoler entre elles les zones devant l'être.

La figure 3b montre le dépôt d'une couche additionnelle 35 en SiN qui sert de référence pour la rectification de la couche de remplissage.

La figure 3c montre le dépôt de la couche de remplissage 36 en SiO2 après planarisation chimico-mécanique CMP avec arrêt sur la couche 35 en SiN.

La figure 3d montre le dépôt et la planarisation d'une seconde couche d'adhésion 37par exemple en SiO2 permettant de réaliser le collage.

Il est également possible de réaliser des niveaux d'interconnexion multiples suivant le principe dit de "double damascène". Après les étapes de la figure 3c, une couche supplémentaire d'oxyde utilisée comme isolation est réalisée (figure 3c1). Cette couche est localement gravée pour réaliser des ouvertures (figure 3c2) correspondant à la liaison électrique entre pistes d'interconnexion. Une couche de Si polycristallin est déposé sur l'ensemble de la plaque, puis une planarisation CMP avec arrêt sur oxyde permet de ne laisser du Si polypolycristallin 39' que dans les ouvertures 39 (figure 3c3).

La figure 3c4 montre les dépôts successifs de couches de nitrure 50 et d'oxyde 51. Des ouvertures 52 sont réalisées par gravure successive de l'oxyde 51 (arrêt sur nitrure) puis du nitrure 50 (arrêt sur oxyde) correspondant aux pistes d'interconnexions (figure 3c5). Les pistes 53 sont réalisées (figure 3c6) par dépôt de Si polycristallin dopé avec planarisation CMP avec arrêt sur l'oxyde constituant la couche 51.

Si un niveau supplémentaire d'interconnexion est nécessaire, le même principe peut être répété : une couche d'oxyde 54 est réalisée avec création d'ouvertures 55 (arrêt sur le Si polycristallin des pistes 53) pour les liaisons électriques (figure 3c7). Ces ouvertures sont remplies de Si polycristallin dopé 56 par dépôt pleine tranche suivi d'une planarisation CMP avec arrêt sur l'oxyde de la couche 54. Les étapes décrites dans les figures 3c4 à 3c6 sont répétées.

A partir des étapes de la figure 3c3, il est possible de remplacer le Si polycristallin par un métal comme par exemple le cuivre.

Dans ce cas, il est possible de remplacer le substrat 8 par un substrat comportant des circuits CMOS et terminé par une couche de plots de Cu dans une matrice de Si02. Pour cette variante, la couche de collage de la figure 3d n'est pas ajoutée, car c'est la couche mixte d'oxyde et de Cu qui fait office de couche de collage. Ce collage permet de réaliser la connexion électrique entre le substrat du système MEMS et le substrat de circuits CMOS associé. Seule une partie des plots métalliques peut servir à la connexion électrique entre le système MEMS et le circuit CMOS, les autres étant réalisés pour augmenter la surface effective de collage. Dans ce cas, la connexion électrique vers l'ensemble MEMS et circuit CMOS se fait à partir de contacts réalisés à la surface du MEMS.

Il est à noter que le principe du collage d'un circuit CMOS à partir d'un réseau de plots métalliques peut être réalisé même si le procédé utilisé pour la réalisation des interconnexions n'est pas planaire. Par exemple, à partir du substrat de la figure 2d', il est possible de réaliser un plan de plots de contacts en ajoutant une couche de nitrure et une couche d'oxyde puis en réalisant le réseau de plot suivant la méthode décrite à partir de la figure 3c4.

Le plan de plots de contacts peut être remplacé par un plan continu métallique connecté à un nombre limité de pistes de connexions du MEMS et permettant de réaliser le contact électrique entre le support et la masse du MEMS.

La figure 4 représente à titre d'exemple un capteur de pression réalisé conformément au procédé selon les figures 1a à 1f. On forme une ouverture 10 à travers le substrat 1 à l'intérieur du périmètre d'un pilier 9 (4₁, 4₂, 6₁) de forme annulaire et on utilise cette ouverture pour enlever la couche sacrificielle 2 à l'intérieur de ce périmètre pour former une cavité 21. On rebouche ensuite l'ouverture 10 de manière connue par exemple avec du PSG (SiO2 dopé phosphore) silicium polycristallin. La région 22 du substrat 1 qui est située dans le périmètre du pilier 9 forme la membrane du capteur de pression et elle est supportée mécaniquement par le pilier.

Il est bien entendu possible de définir une ou plusieurs ouverture 10 pour réaliser des systèmes MEMS de structure plus élaborée par exemple comportant une ou plusieurs poutres encastrées.

Bien que les exemples données illustrent essentiellement la réalisation d'un substrat dont la couche monocristalline est du silicium associée à une couche sacrificielle en SiO2, l'invention permet de réaliser de variantes de substrat et notamment un substrat avec une couche de germanium monocristallin associé à une couche sacrificielle en SiO2 ou encore un substrat avec une couche de pérovskite monocristallin associé à une couche sacrificielle en Si polycristallin ou en Si02.

## Revendications

1. Procédé de fabrication d'une structure électromécanique, le procédé mettant en oeuvre un premier substrat (1) comportant au moins une couche en matériau monocristallin (1') recouverte d'une couche sacrificielle (2) présentant une surface libre, la structure présentant au moins un pilier de renfort mécanique logé dans ladite couche sacrificielle, **caractérisé en ce qu'**il comporte :
a) la réalisation, par gravure de la couche sacrificielle (2), au moins sur toute son épaisseur, d'au moins une région de puits (5₁, 5₂) définissant au moins un dit pilier mécanique ;
b) le dépôt d'une première et d'une deuxième couches de fonctionnalisation (4, 31, 30) respectivement en un premier et en un second matériaux de fonctionnalisation, par rapport auxquels la couche sacrificielle est apte à être gravée sélectivement, l'un des matériaux de fonctionnalisation étant conducteur et l'autre isolant, la première couche de fonctionnalisation (4) remplissant au moins partiellement au moins une région de puits (51) et recouvrant la surface libre de la couche sacrificielle (2) au moins autour de la ou des régions de puits ;
b') le dépôt d'une couche de remplissage isolante (6, 32, 40) en un matériau de remplissage différent du premier et du deuxième matériaux de fonctionnalisation pour terminer le remplissage de la ou des régions de puits (5₁), ladite couche de remplissage (6) recouvrant au moins partiellement la première et/ou la deuxième couches de fonctionnalisation (4) autour de la ou des régions de puits (5₁) et une planarisation de la couche de remplissage (6, 32), le ou les piliers étant formés par la superposition d'au moins du premier ou du deuxième matériaux de fonctionnalisation et du matériau de remplissage dans la ou les régions de puits.
c) l'assemblage du premier substrat avec un deuxième substrat (8), **puis la réalisation d'une ou plusieurs ouvertures (10) à travers ladite couche (1') en matériau monocristallin et** la libération de la structure électromécanique par enlèvement au moins partiellement de la couche sacrificielle (2), une couche d'adhésion étant **ainsi** formée par la couche de remplissage planarisée réalisée sur le premier substrat avant collage.

2. Procédé selon la revendication 1, **caractérisé en ce que** le matériau monocristallin est choisi parmi le Si, le Ge, le quartz, ou un perovskite.

3. Procédé selon une des revendications précédentes, **caractérisé en ce que** la planarisation de la couche de remplissage (6) est poursuivie jusqu'à atteindre l'une des couches de fonctionnalisation (4).

4. Procédé selon une des revendications précédentes, **caractérisé en ce qu'**il met en oeuvre avant l'étape c un dépôt d'une couche d'adhésion sur le premier et/ou le deuxième substrats cette couche formant interface entre ces deux substrats.

5. Procédé selon une des revendications précédentes, **caractérisé en ce que** le premier matériau de fonctionalisation est choisi parmi du nitrure de silicium ou du Si polycristalin dopé ou isolant, un métal ou un polymère.

6. Procédé selon une des revendications précédentes, **caractérisé en ce que** le deuxième matériau de fonctionnalisation est choisi parmi du nitrure de silicium ou du Si polycristalin dopé ou isolant ou un métal.

7. Procédé selon une des revendications précédentes, **caractérisé en ce que** le matériau de remplissage isolant est choisi parmi de l'oxyde de silicium ou un polymère.

8. Procédé selon une des revendications précédentes, **caractérisé en ce qu'**il comporte une étape d de gravure de la couche sacrificielle (2) à travers au moins une ouverture traversante (10) ménagée dans le premier substrat pour libérer la structure électromécanique.

9. Procédé selon une des revendications précédentes, **caractérisé en ce que** avant ou après b', il comporte une étape b" de réalisation au moins dans la première couche de fonctionalisation (4), d'au moins un puits s'étendant au moins jusqu'à la couche sacrificielle (2) ainsi que de dépôt d'un matériau conducteur au moins dans les ou ledit puits pour former au moins une électrode.

10. Procédé selon l'une des revendications précédentes, **caractérisé en ce que** l'une des couches de fonctionnalisation étant conductrice et l'autre isolante, celle des couches de fonctionnalisation qui est conductrice forme un premier niveau d'interconnexion.

11. Procédé selon l'une des revendications précédentes, **caractérisé en ce que** la première couche de fonctionnalisation ne couvre qu'une partie des régions de puits (5₂), l'autre partie (5₁) des régions de puits étant couverte par la deuxième couche de fonctionnalisation (30), permettant la formation à la fois de piliers conducteurs et de piliers isolants.

12. Procédé selon l'une des revendications précédentes **caractérisé en ce que** la couche sacrificielle est couverte par la réunion de la première couche de fonctionnalisation (31) et de la deuxième de fonctionnalisation (30).

13. Procédé selon l'une des revendications précédentes, **caractérisé en ce que** la deuxième couche de fonctionnalisation (30) couvre l'ensemble de la surface de la couche sacrificielle et de la première couche de fonctionnalisation (31).

14. Procédé selon une des revendications précédentes, **caractérisé en ce que** le matériau de remplissage est choisi identique au matériau de la couche sacrificielle.

15. Procédé selon une des revendications précédentes, caractérisé en ce la première couche de fonctionnalisation (31) est isolante, la deuxième couche de fonctionnalisation (30) est conductrice, et en ce qu'il comporte après l'étape b) de dépôt de la deuxième couche de fonctionnalisation (30), une étape b'1 de dépôt d'une couche isolante dite troisième couche de fonctionnalisation.

16. Procédé selon la revendication 15, **caractérisé en ce que** la planarisation de la couche de remplissage (6) est poursuivie jusqu'à atteindre la troisième couche de fonctionnalisation.

17. Procédé selon la revendication 16, **caractérisé en ce qu'**il comporte après b'₁, une étape b'₂) de réalisation d'au moins un via (41) dans ladite troisième couche de fonctionnalisation et d'un dépôt conducteur au moins dans ce via, ce dépôt formant un contact sur la deuxième couche de fonctionnalisation conductrice (30) de façon à former un deuxième niveau d'interconnexion (40).

18. Procédé selon la revendication 17, **caractérisé en ce qu'**il comporte des dépôts successifs de couches de fonctionnalisation additionnelles alternativement en matériau conducteur et en matériau isolant et la réalisation de via de façon à former des niveaux d'interconnexion supplémentaires à partir des couches conductrices.

19. Procédé selon la revendication 17 ou 18 **caractérisé en ce que** le dernier niveau d'interconnexion couvre l'ensemble de la surface pour réaliser un plan de masse.

20. Procédé selon l'une des revendications 16 à 18, **caractérisé en ce que** le dernier niveau d'interconnexion est plan et comporte des plages d'interconnexion pour permettre lors de l'assemblage avec le deuxième substrat de connecter des éléments du deuxième substrat à la structure électromécanique.

21. Structure électromécanique présentant un premier substrat présentant au moins une couche monocristalline (1), **ainsi** qu'au moins un pilier de renfort mécanique logé dans **une** couche **dite** sacrificielle, **et** susceptible d'être fabriquée par un procédé selon une des revendications précédentes, **caractérisée en ce qu'**elle comporte une première et une deuxième couches de fonctionnalisation respectivement en ledit premier et ledit deuxième matériaux de fonctionnalisation par rapport auxquels la couche sacrificielle est au moins partiellement gravée sélectivement, l'un des matériaux de fonctionnalisation étant conducteur et l'autre isolant, au moins un pilier de renfort mécanique étant une région de puits (5₁) logée au moins sur toute l'épaisseur de la couche sacrificielle. (2), la première couche de fonctionnalisation remplissant au moins partiellement au moins une région de puits (5₁) et recouvrant une surface de la couche sacrificielle (2) au moins autour de la ou des régions de puits, et **en ce qu'**il comporte une couche de remplissage (6) en un matériau de remplissage isolant différent du premier et du deuxième matériaux de fonctionnalisation terminant le remplissage de la ou des régions de puits (5₁), le premier substrat (1) étant assemblé avec un deuxième substrat (8) par une couche d'adhésion qui est formée par ladite couche de remplissage (6).

## Claims

1. A method of fabricating an electromechanical structure, the method implementing a first substrate (1) including at least one layer (1') of monocrystalline material covered in a sacrificial layer (2) that presents a free surface, the structure presenting at least one mechanical reinforcing pillar received in said sacrificial layer, the method being **characterized in that** it comprises:
a) making at least one well region (5₁, 5₂) in the sacrificial layer (2) by etching at least the entire thickness thereof, the well region defining at least one said mechanical pillar;
b) depositing respective first and second functionalization layers (4, 31, 30) of first and second functionalization materials, relative to which the sacrificial layer is suitable for being etched selectively, one of the functionalization materials being conductive and the other insulating, the first functionalization layer (4) filling at least one well region (5₁) at least partially and covering the free surface of the sacrificial layer (2) at least around the well region(s); and
b') depositing an insulating filler layer (6, 32, 40) of a filler material different from the first and second functionalization materials for terminating the filling of the well region(s) (5₁), said filler layer (6) covering the first and/or second functionalization layer(s) (4) at least partially around the well region(s) (5₁), and planarizing the filler layer (6, 32), the pillar(s) being formed by the superposition of at least the first or second functionalization material and of the filler material in the well region(s).
c) assembling the first substrate with a second substrate (8), then making one or more openings (10) through said layer (1') of monocrystalline material and releasing the electromechanical structure by removing the sacrificial layer (2) at least partially, a bonding layer thus being formed by the planarized filler layer made on the first substrate prior to bonding.

2. A method according to claim 1, **characterized in that** the monocrystalline material is selected from Si, Ge, quartz, or a perovskite.

3. A method according to any preceding claim, **characterized in that** the filler layer (6) is planarized until the first functionalization layer (4) is reached.

4. A method according to any preceding claim, **characterized in that** prior to step c) it implements depositing a bonding layer on the first substrate and/or on the second substrate, said layer forming an interface between the two substrates.

5. A method according to any preceding claim, **characterized in that** the first functionalization material is selected from: silicon nitride; doped or insulating polycrystalline Si; a metal; and a polymer.

6. A method according to any preceding claim, **characterized in that** the second functionalization material is selected from: silicon nitride; doped or insulating polycrystalline Si; and a metal.

7. A method according to any preceding claim, **characterized in that** the insulating filler material is selected from silicon oxide or a polymer.

8. A method according to any preceding claim, **characterized in that** it includes a step d) of etching the sacrificial layer (2) through at least one through opening (10) formed in the first substrate, in order to release the electromechanical structure.

9. A method according to any preceding claim, **characterized in that** before or after step b'), it includes a step b") of making at least one well in at least the first functionalization layer (4), which well extends at least as far as the sacrificial layer (2), and depositing a conductive material at least in said well(s) in order to form at least one electrode.

10. A method according to any preceding claim, **characterized in that** one of the functionalization layers being conductive and the other insulating, the functionalization layer that is conductive forms a first interconnection level.

11. A method according to any preceding claim, **characterized in that** the first functionalization layer covers a portion (5₂) only of the well region(s), the other portion (5₁) of the well regions being covered by the second functionalization layer (30), thereby enabling the conductive pillars and insulating pillars to be formed.

12. A method according to any preceding claim, **characterized in that** the sacrificial layer is covered by both the first functionalization layer (31) and the second functionalization layer (30), together.

13. A method according to any preceding claim, **characterized in that** the second functionalization layer (30) covers the entire surface of the sacrificial layer and of the first functionalization layer (31).

14. A method according to any preceding claim, **characterized in that** the filler material is selected to be identical to the material of the sacrificial layer.

15. A method according to any preceding claim, **characterized in that** the first functionalization layer (31) is insulating, the second functionalization layer (30) is conductive, and **in that** after step b) of depositing the second functionalization layer (30), it includes a step b'1) of depositing an insulating layer constituting a third functionalization layer.

16. A method according to claim 15, **characterized in that** planarizing the filler layer (6) continues until the third functionalization layer is reached.

17. A method according to claim 16, **characterized in that** after step b'₁), it includes a step b'₂) of making at least one via (41) in said third functionalization layer and of depositing a conductor at least in said via, said deposit forming a contact on the conductive second functionalization layer (30) so as to form a second interconnection level (40).

18. A method according to claim 17, **characterized in that** it includes successively depositing additional functionalization layers alternatively of conductive material and of insulating material and making vias so as to form additional interconnection levels from the conductive layers.

19. A method according to claim 17 or claim 18, **characterized in that** the last interconnection level covers the entire surface so as to make a ground plane.

20. A method according to any one of claims 16 to 18, **characterized in that** the last interconnection level is plane and includes interconnection areas to make it possible, during assembly with the second substrate, to connect elements of the second substrate to the electromechanical structure.

21. An electromechanical structure presenting a first substrate presenting at least one monocrystalline layer (1), as well as at least one mechanical reinforcing pillar received in a sacrificial layer, the structure being suitable for being fabricated by a method according to any preceding claim, and the structure being **characterized in that** it comprises respective first and second functionalization layers of said first and second functionalization materials, relative to which the sacrificial layer is at least partially etched selectively, one of the functionalization materials being conductive and the other insulating, at least one mechanical reinforcing pillar being a well region (5₁) received at least in the entire thickness of the sacrificial layer (2), the first functionalization layer filling at least one well region (5₁) at least partially and covering a surface of the sacrificial layer (2) at least around the well region (s), and **in that** it includes a filler layer (6) of an insulating filler material different from the first and second functionalization materials for terminating the filling of the well region(s) (5₁), the first substrate (1) being assembled with a second substrate (8) by a bonding layer that is formed by said filler layer (6).

## Patentansprüche

1. Verfahren zur Herstellung einer elektromechanischen Struktur, wobei bei dem Verfahren ein erstes Substrat (1) mit mindestens einer Schicht (1') aus monokristallinem Material angewendet wird, die mit einer Opferschicht (2) mit einer freien Oberfläche bedeckt ist, wobei die Struktur mindestens eine in der Opferschicht angeordnete mechanische Verstärkungsstütze aufweist, **dadurch gekennzeichnet, dass** es Folgendes umfasst:
a) Bilden mindestens eines Senkenbereichs (5₁, 5₂), der mindestens eine mechanische Stütze bildet, durch Ätzen der Opferschicht (2) zumindest auf ihrer gesamten Dicke;
b) Abscheiden einer ersten und einer zweiten Funktionalisierungsschicht (4, 31, 30) aus einem ersten bzw. zweiten Funktionalisierungsmaterial, in Bezug auf die die Opferschicht selektiv geätzt werden kann, wobei eines der Funktionalisierungsmaterialien leitend und das andere isolierend ist und die erste Funktionalisierungsschicht (4) zumindest teilweise mindestens einen Senkenbereich (5₁) füllt und die freie Oberfläche der Opferschicht (2) zumindest um den Senkenbereich oder die Senkenbereiche herum bedeckt;
b') Abscheiden einer isolierenden Füllschicht (6, 32, 40) aus einem Füllmaterial, das sich von dem ersten und von dem zweiten Funktionalisierungsmaterial unterscheidet, um das Füllen des Senkenbereichs oder der Senkenbereiche (5₁) zu beenden, wobei die Füllschicht (6) die erste und/oder die zweite Funktionalisierungsschicht (4) um den Senkenbereich oder um die Senkenbereiche (5₁) herum zumindest teilweise bedeckt, und Planarisieren der Füllschicht (6, 32), wobei die Stütze(n) dadurch gebildet werden, dass zumindest das erste oder das zweite Funktionalisierungsmaterial und das Füllmaterial in dem Senkenbereich oder in den Senkenbereichen übereinandergelegt werden;
c) Zusammenfügen des ersten Substrats mit einem zweiten Substrat (8), anschließend Ausbilden einer oder mehrerer Öffnungen (10) durch die Schicht (1') aus monokristallinem Material und Freigeben der elektromechanischen Struktur durch zumindest teilweises Entfernen der Opferschicht (2), wobei somit eine Haftschicht durch die planarisierte Füllschicht gebildet wird, die vor dem Kleben auf dem ersten Substrat ausgebildet wird.

2. Verfahren nach Anspruch 1, **dadurch gekennzeichnet, dass** das monokristalline Material aus Si, Ge, Quarz oder einem Perowskit ausgewählt ist.

3. Verfahren nach einem der vorhergehenden Ansprüche, **dadurch gekennzeichnet, dass** das Planarisieren der Füllschicht (6) fortgesetzt wird, bis eine der Funktionalisierungsschichten (4) erreicht ist.

4. Verfahren nach einem der vorhergehenden Ansprüche, **dadurch gekennzeichnet, dass** es vor Schritt c) ein Abscheiden einer Haftschicht auf das erste und/oder das zweite Substrat umfasst, wobei diese Schicht eine Verbindungsstelle zwischen diesen beiden Substraten bildet.

5. Verfahren nach einem der vorhergehenden Ansprüche, **dadurch gekennzeichnet, dass** das erste Funktionalisierungsmaterial aus Siliciumnitrid oder dotiertem oder isolierendem polykristallinem Si, einem Metall oder einem Polymer ausgewählt ist.

6. Verfahren nach einem der vorhergehenden Ansprüche, **dadurch gekennzeichnet, dass** das Funktionalisierungsmaterial aus Siliciumnitrid oder dotiertem oder isolierendem polykristallinem Si oder einem Metall ausgewählt ist.

7. Verfahren nach einem der vorhergehenden Ansprüche, **dadurch gekennzeichnet, dass** das isolierende Füllmaterial aus Siliciumoxid oder einem Polymer ausgewählt ist.

8. Verfahren nach einem der vorhergehenden Ansprüche, **dadurch gekennzeichnet, dass** es einen Schritt d) umfasst, bei dem die Opferschicht (2) durch mindestens eine im ersten Substrat ausgebildete Durchgangsöffnung (10) geätzt wird, um die elektromechanische Struktur freizugeben.

9. Verfahren nach einem der vorhergehenden Ansprüche, **dadurch gekennzeichnet, dass** es vor oder nach b') einen Schritt b") umfasst, bei dem zumindest in der ersten Funktionalisierungsschicht (4) mindestens eine Senke ausgebildet wird, die sich zumindest bis zur Opferschicht (2) erstreckt, und ein leitendes Material zumindest in der Senke oder in den Senken abgeschieden wird, um mindestens eine Elektrode zu bilden.

10. Verfahren nach einem der vorhergehenden Ansprüche, **dadurch gekennzeichnet, dass** dadurch, dass eine der Funktionalisierungsschichten leitend und die andere isolierend ist, die Funktionalisierungsschicht, die leitend ist, eine erste Verbindungsebene bildet.

11. Verfahren nach einem der vorhergehenden Ansprüche, **dadurch gekennzeichnet, dass** die erste Funktionalisierungsschicht nur einen Teil der Senkenbereiche (5₂) bedeckt, wobei der andere Teil (5₁) der Senkenbereiche mit der zweiten Funktionalisierungsschicht (30) bedeckt ist, wodurch sowohl leitende Stützen als auch isolierende Stützen gebildet werden können.

12. Verfahren nach einem der vorhergehenden Ansprüche, **dadurch gekennzeichnet, dass** die Opferschicht durch die Vereinigung der ersten Funktionalisierungsschicht (31) und der zweiten Funktionalisierungsschicht (30) bedeckt ist.

13. Verfahren nach einem der vorhergehenden Ansprüche, **dadurch gekennzeichnet, dass** die zweite Funktionalisierungsschicht (30) die gesamte Oberfläche der Opferschicht und die erste Funktionalisierungsschicht (31) bedeckt.

14. Verfahren nach einem der vorhergehenden Ansprüche, **dadurch gekennzeichnet, dass** das Füllmaterial so ausgewählt ist, dass es mit dem Material der Opferschicht identisch ist.

15. Verfahren nach einem der vorhergehenden Ansprüche, **dadurch gekennzeichnet, dass** die erste Funktionalisierungsschicht (31) isolierend ist, die zweite Funktionalisierungsschicht (30) leitend ist und es nach Schritt b) zum Abscheiden der zweiten Funktionalisierungsschicht (30) einen Schritt b'1) umfasst, bei dem eine dritte Funktionalisierungsschicht genannte isolierende Schicht abgeschieden wird.

16. Verfahren nach Anspruch 15, **dadurch gekennzeichnet, dass** das Planarisieren der Füllschicht (6) fortgesetzt wird, bis die dritte Funktionalisierungsschicht erreicht ist.

17. Verfahren nach Anspruch 16, **dadurch gekennzeichnet, dass** es nach b'₁) einen Schritt b'₂) umfasst, bei dem mindestens eine Durchkontaktierung (41) in der dritten Funktionalisierungsschicht und eine leitende Abscheidung zumindest in dieser Durchkontaktierung realisiert werden, wobei diese Abscheidung einen Kontakt auf der zweiten, leitenden Funktionalisierungsschicht (30) bildet, so dass eine zweite Verbindungsebene (40) gebildet wird.

18. Verfahren nach Anspruch 17, **dadurch gekennzeichnet, dass** es aufeinanderfolgende Abscheidungen von zusätzlichen Funktionalisierungsschichten, die abwechselnd aus leitendem und isolierendem Material bestehen, und die Bildung von Durchkontaktierungen umfasst, so dass ausgehend von den leitenden Schichten zusätzliche Verbindungsebenen gebildet werden.

19. Verfahren nach Anspruch 17 oder 18, **dadurch gekennzeichnet, dass** die letzte Verbindungsebene die gesamte Oberfläche bedeckt, um eine Masseebene zu bilden.

20. Verfahren nach einem der Ansprüche 16 bis 18, **dadurch gekennzeichnet, dass** die letzte Verbindungsebene plan ist und Verbindungsbereiche aufweist, um beim Zusammenfügen mit dem zweiten Substrat das Anschließen von Elementen des zweiten Substrats an die elektromechanische Struktur zu ermöglichen.

21. Elektromechanische Struktur, die ein erstes Substrat mit mindestens einer monokristallinen Schicht (1) und mindestens eine mechanische Verstärkungsstütze aufweist, die in einer sogenannten Opferschicht angeordnet ist, und die mit einem Verfahren nach einem der vorhergehenden Ansprüche hergestellt werden kann, **dadurch gekennzeichnet, dass** sie eine erste und zweite Funktionalisierungsschicht aus einem ersten bzw. zweiten Funktionalisierungsmaterial aufweist, in Bezug auf die die Opferschicht zumindest teilweise selektiv geätzt ist, wobei eines der Funktionalisierungsmaterialien leitend und das andere isolierend ist, wobei mindestens eine mechanische Verstärkungsstütze ein Senkenbereich (5₁) ist, der zumindest über die gesamte Dicke der Opferschicht (2) angeordnet ist, wobei die erste Funktionalisierungsschicht zumindest teilweise mindestens einen Senkenbereich (5₁) füllt und eine Oberfläche der Opferschicht (2) zumindest um den Senkenbereich oder die Senkenbereiche herum füllt, und sie eine Füllschicht (6) aufweist, die aus einem isolierenden Füllmaterial besteht, das sich von dem ersten und dem zweiten Funktionalisierungsmaterial unterscheidet, und das Füllen des Senkenbereichs oder der Senkenbereiche (5₁) beendet, und wobei das erste Substrat (1) durch eine Haftschicht, die durch die Füllschicht (6) gebildet wird, mit einem zweiten Substrat (8) zusammengefügt ist.
